# NEUE EUROPÄISCHE PATENTSCHRIFT

(11) **EP 1 351 302 B2**
(45) Veröffentlichungstag und Bekanntmachung des Hinweises auf die Entscheidung über den Einspruch: **17.10.2018**
(45) Hinweis auf die Patenterteilung: 24.02.2016
(21) Anmeldenummer: 03005024.9
(22) Anmeldetag: 06.03.2003
(51) Int. Cl.: H01L 25/07, H01L 25/11, H05K 1/18, H01L 23/40, H01L 23/48, H05K 3/32, H05K 3/00, H05K 1/03

(54) **Leistungshalbleitermodul**
Power semiconductor module
Module à sémi-conducteur de puissance

(30) Priorität: 27.03.2002 DE 10213648
(43) Veröffentlichungstag der Anmeldung: 08.10.2003
(73) Patentinhaber: SEMIKRON Elektronik GmbH & Co. KG, 90431 Nürnberg (DE)
(72) Erfinder: Göbl, Christian, 90441 Nürnberg (DE)

(56) Entgegenhaltungen:
- EP-A- 0 625 871
- EP-A- 1 028 520
- DE-A1- 19 630 173
- DE-C1- 3 628 556
- DE-C1- 19 529 237
- US-A- 5 982 031
- KAUFMANN S ET AL: "10 kV IGBT press pack modules with series connected chips" PROCEEDINGS OF THE 14TH. INTERNATIONAL SYMPOSIUM ON POWER SEMICONDUCTOR DEVICES & ICS. ISPSD'02. SANTA FE, NM, JUNE 4 - 7, 2002, INTERNATIONAL SYMPOSIUM ON POWER SEMICONDUCTOR DEVICES & IC'S, NEW YORK, NY : IEEE, US, 4. Juni 2002 (2002-06-04), Seiten 89-92, XP010591573 ISBN: 0-7803-7318-9

## Beschreibung

Die Erfindung beschreibt ein Leistungshalbleitermodul mit aktiven und / oder passiven Bauelementen, insbesondere ein Stromrichtermodul. Derartige Leistungshalbleitermodule sind mehrfach aus der Literatur bekannt. Bei der Erhöhung der Leistungsfähigkeit, der Zuverlässigkeit sowie der Lebensdauer bei gleichzeitig verringerten Herstellungskosten sind veränderte Methoden der Aufbautechnologien für die einzelnen Bestandteile eine zwingende Voraussetzung.

Moderne Leistungshalbleitermodule, die Ausgangspunkt dieser Erfindung sind, sind grundplattenlose Module, wie beispielhaft in der DE 199 03 875 A1 beschrieben, bestehend aus
- einem Gehäuse;
- einem keramischen Substrat mit darauf angeordneten schaltungsgerecht ausgeführten metallischen Kaschierungen, wie sie z.B. nach dem DCB- (direct copper bonding) Verfahren hergestellt werden;
- auf diesem Substrat mittels Löttechnik stoffschlüssig aufgebrachten Bauelementen, wie beispielhaft Dioden, Transistoren, Widerständen oder Sensoren;
- Bondverbindungen zur Verbindung der strukturierten Seite der chipförmigen, ungehausten Leistungshalbleiterbauelemente mit weiteren Bauelementen und/oder dem Substrat und / oder nach außen führenden Anschlusselementen.
- Einer vorzugsweise aus Silikonkautschuk bestehenden Vergussmasse zur Isolation der einzelnen Bauelemente zueinander.

Es hat sich gezeigt, dass sich insbesondere großflächige Lötverbindungen zu einem Kühlbauteil nur sehr schwer qualitätsgerecht beherrschen lassen, worunter die Zuverlässigkeit sowie die Lebensdauer der Leistungshalbleitermodule leiden. Sehr vorteilhaft hat daher sich für derartige Leistungshalbleitermodule die Aufbautechnologie mit Druckkontakt zur thermisch leitenden Verbindung des Moduls mit einem Kühlbauteil erwiesen.

Der Druckaufbau in derartigen druckkontaktierten Leistungshalbleitermodulen wird mittels einer mechanisch stabilen Druckplatte erzielt. Je nach weiterer Ausgestaltung kann der erzeugte Druck direkt mittels speziell ausgestalteter Druckstücke der Druckplatte, wie beispielhaft in der DE 42 37 632 A1 gezeigt, oder mittels eines elastischen Druckspeichers nach der DE 199 03 875 A1, auf das Substrat übertragen werden.

Den Leistungshalbleitermodulen nach DE 42 37 632 A1 oder DE 199 03 875 A1 haftet der Nachteil an, dass, wie bei modernen Modulen üblich, eine Vielzahl von Leistungshalbleiterbauelementen miteinander und / oder mit dem Substrat kontaktiert werden müssen. Technisch wird dies mittels einer Vielzahl einzelner Drahtbondverbindungen realisiert. Üblich sind hier durchaus bis zu 10 Bondverbindungen pro Bauelement. Da diese Bondverbindungen seriell hergestellt werden, erfordert ihre Herstellung einen erheblichen Zeitaufwand und verursacht damit auch einen wesentlichen Kostenanteil an der Modulherstellung.

Aus der EP 0 625 871 A1 ist weiterhin ein Gehäuse für gehauste Leistungshalbleiterbauelemente bekannt, wobei eine Mehrzahl dieser Leistungshalbleiterbauelemente in dem Gehäuse angeordnet sind. Die Gehäuse der Leistungshalbleiterbauelemente werden hierbei elastisch mittels eines gemeinsamen Deckels auf eine Grundfläche gedrückt.

Aus der DE 36 28 556 C1 ist eine Halbleiteranordnung mit einem gehausten Leistungshalbleiterbauelement bekannt, das auf einem Substrat angeordnet ist. Auf diesem Substrat sind weiterhin Kontaktelemente zur externen Kontaktierung beispielhaft mit einer Leiterplatte angeordnet.

Aus der DE 195 29 237 C1 ist eine Schaltungsanordnung der Halbleiterelektronik mit großer Leistungsdichte bekannt. Auf der Grundlage eines Druckkontaktaufbaus wird durch zusätzliche Maßnahmen die Lebensdauer der Bondverbindungen erhöht, wodurch die Zuverlässigkeit der gesamten Anordnung vergrößert wird. Die erhöhte Qualität der Bondverbindungen wird durch einen Aufbau mit Druckkissen erreicht. Die Druckkissen sind erfindungsgemäß so gestaltet, dass die gebondeten Verbindungsdrähte der internen Schaltungsverdrahtung gegen die Bondkontaktflächen gedrückt werden.

Die vorliegende Erfindung hat die Aufgabe ein Leistungshalbleitermodul vorzustellen, bei dem zumindest teilweise auf Bondverbindungen zur elektrischen Verbindung der Halbleiterbauelemente mit den Kontaktflächen des Substrats verzichtet werden kann.

Die Aufgabe wird gelöst durch die Maßnahmen des Anspruchs 1. Weitere vorteilhafte Ausgestaltungen sind in den Unteransprüchen genannt.

Der grundlegende erfinderische Gedanke liegt darin zumindest ein ungehaustes, chipförmiges Leistungshalbleiterbauelement durch ein gehaustes Leistungshalbleiterbauelement zu ersetzen. Gehauste Leistungshalbleiterbauelemente nach dem Stand der Technik weisen die gleichen elektrischen Parameter auf wie die in Leistungshalbleitermodulen eingesetzten Leistungshalbleiterbauelemente. Gehauste Varianten weisen allerdings gegenüber den ungehausten den Vorteil auf, dass Sie über aus dem Gehäuse herausgeführte Kontaktelemente verfügen, mit denen sich die gleichen elektrischen Kontakte herstellen lassen, wie sie nach dem Stand der Technik mittels der Drahtbondverbindungen hergestellt werden. Die gehausten Leistungshalbleiterbauelemente lassen sich ebenso wie die ungehausten mittels vielfältiger Verbindungstechniken mit dem Substrat verbinden.

Spezielle Ausgestaltungen erfinderischer Leistungshalbleitermodule werden anhand der Fig. 1 bis 5 näher erläutert.
Fig. 1 zeigt ein Leistungshalbleitermodul nach dem Stand der Technik
Fig. 2 zeigt eine Abwandlung eines Leistungshalbleitermoduls gemäß Fig. 1.
Fig. 3 zeigt eine weitere Abwandlung eines Leistungshalbleitermoduls gemäß Fig. 1 mit Druckkontaktierung.
Fig. 4 zeigt eine Ausgestaltung eines Halbleitermoduls mit Druckkontaktierung ohne Vergussmasse.
Fig. 5 zeigt eine erfinderische Ausgestaltung eines Halbleitermoduls nach Fig. 3

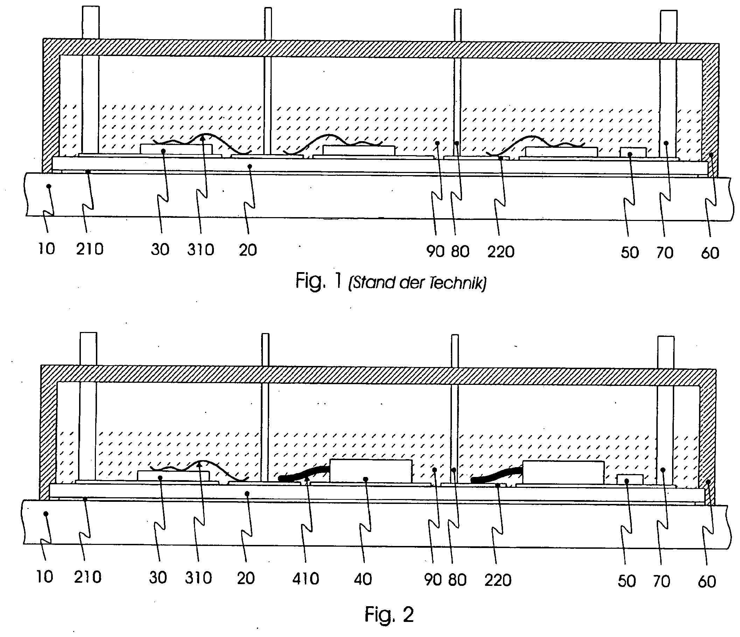

Fig. 1 zeigt ein Leistungshalbleitermodul auf einem Kühlkörper (10) nach dem Stand der Technik, wobei das Leistungshalbleitermodul besteht aus einem Substrat (20) mit einer ersten dem Kühlkörper zugewandten flächigen metallischen Kaschierung (210), einer zweiten schaltungsgerecht strukturierten metallischen Kaschierung (220). Auf dieser zweiten metallischen Kaschierung sind ungehauste chipförmige Leistungshalbleiterbauelemente (30) angeordnet und elektrisch leitend mit dieser verbunden. Hierzu dienen verschiedenen Verbindungstechniken, die am häufigsten eingesetzte ist die Lötverbindung, allerdings sind auch Klebeverbindungen mittels leitfähiger Kleber bekannt. Weitere elektrische Verbindungen der dem Substrat abgewandten Seite der Leistungshalbleiterbauelemente (30) werden nach dem Stand der Technik meist mittels Drahtbondverbindungen (310) hergestellt. Zur elektrischen Isolierung der einzelnen Bauelemente ist in das Gehäuse (60) noch eine Vergussmasse (90) eingebracht. Weiterhin dienen elektrische Kontaktierungen als Haupt-(70) und Hilfsanschlüsse (80), die das Substrat mit externen Anschlüssen verbinden. Auf dem Substrat können weitere Bauelemente wie beispielhaft Sensoren (50) angeordnet sein.

Fig. 2 zeigt ein Leistungshalbleitermodul, wobei einzelne chipförmige ungehauste Leistungshalbleiterbauelemente (30) durch gehauste Leistungshalbleiterbauelemente (40) ersetzt sind. Diese Bauelemente sind mit der zweiten metallischen Kaschierung (220) des Substrates mittels Lötverbindung oder mittels einer Klebetechnik mit thermisch leitfähigem Kleber verbunden. Wichtig ist hierbei, dass der Wärmeübergang vom Leistungshalbleiterbauelement (40) zur Wärmesenke, dem Kühlbauteil (10), ein der Aufbautechnik nach dem Stand der Technik vergleichbares Maß aufweist. Dies ist beispielhaft durch den Einsatz bekannter gehauster Halbleiterbauelemente (40) im "TO-" Gehäuse mit integrierter Wärmespreizung gewährleistet. Die Kontaktelemente (410) des gehausten Leistungshalbleiterbauelements (40) werden durch Lötverbindungen mit den entsprechenden Kontaktflächen, Teilen der metallischen Kaschierung (220) des Substrates, verbundenen. Alle weiteren Komponenten des Leistungshalbleitermoduls nach dem Stand der Technik (vgl. Fig. 1), wie Sensoren (50) und Anschlusselemente (70 und 80) finden sich hier ebenfalls.

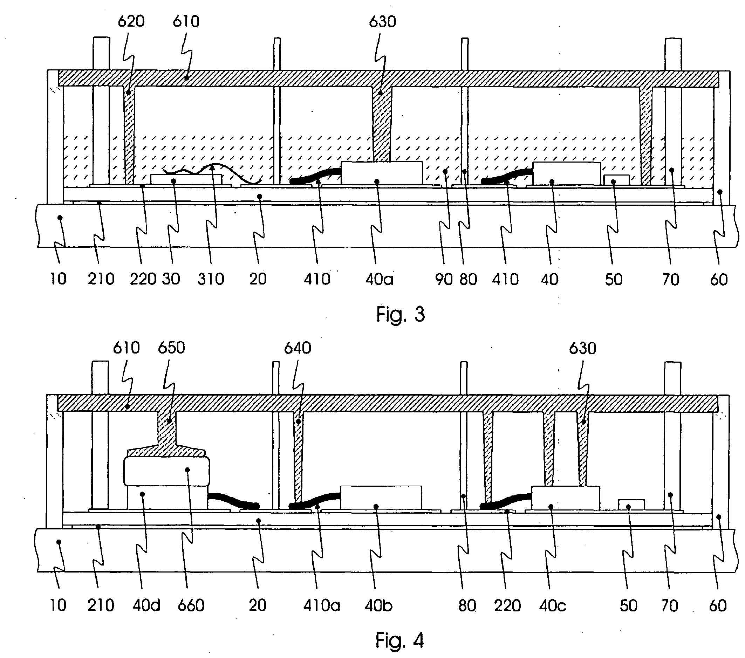

Fig. 3 zeigt ein Leistungshalbleitermodul mit Druckkontaktierung. Hierbei wird eine Druckkontaktierung nach dem Stand der Technik gezeigt, die mittels einzelner Druckstücke (620) eines separaten Deckels (610) als Teil des Gehäuses (60) das Substrat (20) auf das Kühlbauteil drücken und somit einen sehr wirkungsvollen Wärmeübergang zwischen den Bauelementen des Leistungshalbleitermoduls und dem Kühlbauteil gewährleisten. Diese Druckeinrichtung ist erweitert um Druckstücke (630) zur Druckkontaktierung der gehausten Leistungshalbleiterbauelemente (40a). Somit kann auf eine stoffschlüssige Verbindung, wie eine Lötung, verzichtet werden, um einen thermischen leitenden Kontakt zur Wärmeabführung des Leistungshalbleiterbauelements auf das Substrat bzw. das Kühlbauteil zu ermöglichen. Zwischen Leistungshalbleiterbauelement (40) und Substrat (20), bzw. Kontaktfläche (220), kann zusätzlich ein wärmeleitendes Medium angeordnet sein.

Fig. 4 zeigt eine Ausgestaltung eines Halbleitermoduls mit Druckkontaktierung ohne Vergussmasse. Hierbei wird die Druckkontaktierung aus Fig. 3 erweitert, indem auch auf die Kontaktelemente (410a) des Leistungshalbleiterbauelements (40b) mittels eines Druckstücks (640) Druck eingeleitet wird. Hierdurch kann auf eine Löt- oder Klebekontaktierung dieses Kontaktelements (410a) verzichtet werden. Es wird so ein elektrisch leitender Kontakt zwischen den Kontaktelementen des Leistungshalbleiterbauelements und der entsprechenden Kontaktfläche (220) des Substrats hergestellt. Vorteilhafterweise werden sowohl das Leistungshalbleiterbauelement (40c) als auch dessen Kontaktelemente mittels geeigneter Druckstücke auf das Substrat gedrückt. Somit kann sowohl der thermisch leitende Übergang zur Wärmeabführung als auch der elektrisch leitende Übergang zur elektrischen Kontaktierung unter Verzicht auf Lötverbindungen hergestellt werden. Die Druckeinrichtung kann weiterhin durch ein elastisches Kissenelement (660) nach dem Stand der Technik ergänzt werden. Hierbei wird dann der Druck des Druckstücks (650) nicht direkt auf das Leistungshalbleiterbauelement (40d) eingeleitet, sondern auf ein dauerelastisches Druckkissen (660), welches seinerseits den Druck auf das Leistungshalbleiterbauelement (40d) überträgt. Das Druckkissen kann derart ausgestaltet sein, dass es eines oder mehrere Leistungshalbleiterbauelemente überdeckt und darauf Druck überträgt.

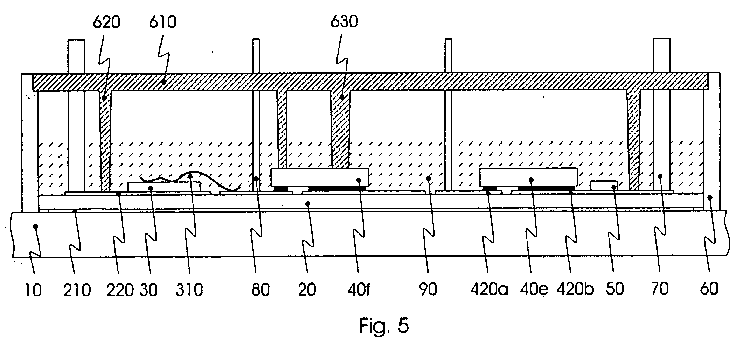

Fig. 5 zeigt eine erfinderische Ausgestaltung eines Leistungshalbleitermoduls nach Fig. 3. Hier werden andere Bauformen des Leistungshalbleiterbauelements (40e) derart auf dem Substrat angeordnet, dass die Kontaktelemente (420a und 420b) mit den jeweils schaltungsgerechten Kontaktflächen (220) des Substrates (20) verbunden werden. Auch für derartige Leistungshalbleiterbauelemente (40e, 40f) bieten sich die bereits oben genannten Möglichkeiten zur thermischen und elektrischen Kontaktierung an. Das Leistungshalbleiterbauelement (40e) wird per stoffschlüssiger Verbindung, beispielhaft einer Lötverbindung kontaktiert, während das Leistungshalbleiterbauelement (40f) mittels einer Druckkontaktierung mit Druckstücken (630) thermisch und elektrisch kontaktiert wird.

Der Einsatz gehauster Leistungshalbleiterbauelemente in erfinderischen Leistungshalbleitermodulen weist folgenden Vorteile gegenüber dem Stand der Technik auf:
- Die Herstellung eines Leistungshalbleitermoduls wird vereinfacht, da keine oder weniger mechanisch empfindliche ungehauste Leistungshalbleiterbauelemente verwendet werden.
- Die Herstellung eines erfinderischen Leistungshalbleitermoduls kann mit den gleichen Werkzeuge erfolgen wie sie beim Stand der Technik üblich sind.
- Die Herstellung eines Leistungshalbleitermoduls wird beschleunigt, da auf aufwändige Drahtbondverbindungen zumindest zum Teil verzichtet werden kann.
- Das Leistungshalbleitermodul wird bereits in einem früheren Stadium seiner Herstellung testfähig, da die Isolierung der Bauelemente durch ihr Gehäuse sichergestellt ist und nicht erst durch das Einbringen einer Vergussmasse erreicht wird.
- Die gehausten Leistungshalbleiterbauelemente sind direkt einer Druckkontaktierung zugänglich, da ihre Gehäuse selbst mit Druck beaufschlagt werden können.
- Auf den Einsatz von Vergussmassen kann verzichtet werden, oder es kann deren Einsatz zumindest verringert werden.
- Die Leistungshalbleitermodule werden einer Reparatur zugänglich, da einzelne nicht mit auf das Substrat gelötete defekte Leistungshalbleiterbauelemente ersetzt werden können.

### Bezeichnungsliste

- 10: Kühlbauteil
- 20: Substrat
- 210: erste metallische Kaschierung des Substrats 20
- 220: zweite metallische Kaschierung des Substrats 20
- 30: ungehaustes Leistungshalbleiterbauelement
- 310: Drahtbondverbindungen
- 40: gehaustes Leistungshalbleiterbauelement
- 410: Kontaktelement eines Leistungshalbleiterbauelements 40
- 420: Kontaktelement eines Leistungshalbleiterbauelements 40
- 50: Sensor
- 60: Gehäuse
- 610: Deckel des Gehäuses 60
- 620: Druckstück zum Druck auf das Substrat 20
- 630: Druckstück zum Druck auf das Leistungshalbleiterbauelement 40
- 640: Druckstück zum Druck auf Kontaktelemente 410
- 650: Druckstück zum Druck auf ein Kissenelement 660
- 660: Kissenelement
- 70: Anschlusselement
- 80: Anschlusselement
- 90: Vergussmasse

## Patentansprüche

1. Leistungshalbleitermodul, zur Druckkontaktierung mit einem Kühlbauteil (10), bestehend aus einem Gehäuse (60), mindestens einem Substrat (20), darauf schaltungsgerecht angeordneten strukturierten und elektrisch leitenden Kontaktflächen (220), mindestens einem darauf angeordneten gehausten Leistungshalbleiterbauelement (40 b/c, 40 e/f), mit Kontaktelementen (410a, 420 a/b), wobei diese Kontaktelemente (410a, 420 a/b) mit mindestens einer der Kontaktflächen (220) verbunden sind, sowie Anschlusselementen (70, 80) zur elektrischen Kontaktierung des Leitungshalbleitermoduls wobei
das Gehäuse (60) einen Deckel (610) zur Druckkontaktierung, mit oder ohne Druck speicherndes elastisches Kissenelement, aufweist und wobei der Druck über Druckstücke (640) auf die Kontaktelemente (410a, 420 a/b) des Leistungshalbleiterbauelements (40 b/c, 40 e/f) eingeleitet wird wodurch ein elektrisch leitender Kontakt zwischen den Kontaktelementen (10, 410a, 420 a/b) des Leistungshalbleiterbauelements (40 b/c, 40 e/f) und der entsprechenden Kontaktfläche (220) auf dem Substrat (20) hergestellt wird und wobei zusätzlich zu gehausten (40 b/c, 40 e/f) auch ungehauste (30) Leistungshalbleiterbauelemente auf Kontaktflächen (220) des Substrats (20) angeordnet sind.

2. Leistungshalbleitermodul nach Anspruch 1, wobei
der Druck über weitere Druckstücke (620, 630, 650) eingeleitet wird auf das Substrat (20) und/oder auf das Leistungshalbleiterbauelement (40c, 40f) und/oder über ein Kissenelement (660) auf das Leistungshalbleiterbauelement (40d).

3. Leistungshalbleitermodul nach Anspruch 1, wobei
das Leistungshalbleiterbauelement (40) durch eine stoffschlüssige Verbindung oder eine Druckkontaktierung auf dem Substrat (20, 220) fixiert ist.

## Claims

1. Power semiconductor module for pressure contacting with a cooling component (10), consisting of a housing (60), at least one substrate (20), structured and electrically conductive contact areas (220) arranged thereon in a circuit-conforming manner, at least one packaged power semiconductor component (40 b/c, 40 e/f) arranged thereon, comprising contact elements (410a, 420a/b), wherein said contact elements (410a, 420a/b) are connected to at least one of the contact areas (220), and connection elements (70, 80) for electrically contacting the power semiconductor module wherein the housing (60) has a cover (610) for pressure contacting, with or without a pressure-storing elastic cushion element, and wherein the pressure is introduced on the contact elements (410a, 420a/b) of the power semiconductor component (40 b/c, 40 e/f) by means of pressure pieces (640), as a result of which an electrically conductive contact between the contact elements (410a, 420a/b) of the power semiconductor component (40 b/c, 40 e/f) and the corresponding contact area (220) on the substrate (20) is produced and wherein, in addition to packaged power semiconductor components (40 b/c, 40 e/f), unpackaged power semiconductor components (30) are also arranged on contact areas (220) of the substrate (20).

2. Power semiconductor module according to Claim 1, wherein the pressure is introduced on the substrate (20) and/or on the power semiconductor component (40c, 40f) by means of further pressure pieces (620, 630, 650) and/or on the power semiconductor component (40d) by means of a cushion element (660).

3. Power semiconductor module according to Claim 1, wherein the power semiconductor component (40) is fixed by a cohesive connection or a pressure contact-connection on the substrate (20, 220).

## Revendications

1. Module à semi-conducteur de puissance, pour le contact par pression avec un composant de refroidissement (10), consistant en un boîtier (60), au moins un substrat (20), des surfaces de contact (220) structurées et électriquement conductrices, disposées de manière correspondant au circuit, au moins un composant semi-conducteur de puissance enfermé dans un boîtier (40 b/c, 40 e/f) et disposé sur celles-ci, avec des éléments de contact (410a, 420 a/b), ces éléments de contact (410a, 420 a/b) étant connectés à au moins l'une des surfaces de contact (220), et des éléments de raccordement (70, 80) pour le contact électrique avec le module semi-conducteur de puissance,
le boîtier (60) présentant un couvercle (610) pour le contact par pression, avec ou sans éléments de coussin élastique d'accumulation de pression, et la pression étant introduite par le biais de pièces de pression (640) sur les éléments de contact (410a, 420 a/b) du composant semi-conducteur de puissance (40 b/c, 40 e/f), de sorte qu'un contact électriquement conducteur entre les éléments de contact (410a, 420 a/b) du composant semi-conducteur de puissance (40 b/c, 40 e/f) et la surface de contact correspondante (220) sur le substrat (20) soit établi et dans lequel en plus des composant semi-conducteur de puissance enfermés dans un boîtier (40 b/c, 40e/f), des composant semi-conducteur de boîtier non enfermés dans un boîtier (30) sont disposés sur des surfaces de contact (220) du substrat (20).

2. Module semi-conducteur de puissance selon la revendication 1, dans lequel la pression est introduite par le biais d'autres pièces de pression (620, 630, 650) sur le substrat (20) et/ou sur le composant semi-conducteur de puissance (40c, 40f) et/ou par le biais d'un élément de coussin (660) sur le composant semi-conducteur de puissance (40d).

3. Module semi-conducteur de puissance selon la revendication 1, dans lequel le composant semi-conducteur de puissance (40) est fixé par une connexion par liaison de matière ou par un contact par pression sur le substrat (20, 220).
